# EUROPÄISCHE PATENTANMELDUNG

(11) **EP 0 889 531 A1**
(43) Veröffentlichungstag der Anmeldung: **07.01.1999**
(21) Anmeldenummer: 98810484.0
(22) Anmeldetag: 25.05.1998
(51) Int. Cl.: H01L 29/739

(54) **MOS gesteuertes Halbleiterbauelement**

(30) Priorität: 30.06.1997 DE 19727676
(71) Anmelder: Asea Brown Boveri AG, 5401 Baden (CH)
(72) Erfinder: Bauer, Friedhelm, Dr., 5702 Niederlenz (CH)
(74) Vertreter: Weibel, Beat

(57) **Zusammenfassung**

Es wird ein MOS gesteuertes Leistungshalbleiterbauelement angegeben. Durch Gräben werden Emitterfinger und Kollektorfinger gebildet. Nur die Emitterfinger weisen Sourcegebiete auf. Den Kollektorfingern fehlen diese Gebiete. Die Kollektorfinger sind mit einer dünnen, hochdotierten Schicht ausgestattet sein, die einen guten elektrischen Kontakt zu der Kathode ermöglicht. Zwischen zwei Emitterfingern sind mindestens ein, vorzugsweise mindestens drei, Kathodenfinger angeordnet.

## Beschreibung

### Technisches Gebiet

Die Erfindung bezieht sich auf das Gebiet der Leistungshalbleitertechnologie. Sie geht aus von einem MOS gesteuerten Leistungshalbleiterbauelement nach dem Oberbegriff des ersten Anspruchs.

### Stand der Technik

Ein gattungsgemässes Leistungshalbleiterbauelement wird zum Beispiel in der Deutschen Offenlegungsschrift DE 195 00 588 A1 beschrieben. In dieser Schrift wird ein IGBT (Bipolartransistor mit isoliert angeordneter Steuerelektrode) angegeben. Der IGBT weist eine dreidimensionale MOS Struktur auf. Die Abmessungen der dreidimensionalen Struktur senkrecht zur axialen Richtung sind dabei ungefähr von derselben Grössenordnung. Besonders bevorzugt werden säulenförmige Strukturen.

Aus der EP 0 494 597 B1 ist ebenfalls ein MOS gesteuertes Leistungshalbleiterbauelement mit Grabenstruktur bekannt. Durch die Verwendung einer vergrabenen Schicht im Bereich des Bodens des Grabens wird versucht, den Durchlasswiderstand zu vermindern und eine hohe Durchbruchspannung zu erreichen.

Solche Trench- oder Graben-IGBTs erlauben aufgrund der Plasmaanreicherung auf der Kathodenseite den Durchlassspannungsabfall in den Bereich von GTOs zu schieben. Um die Durchlassverluste weiter zu verringern, wäre eine Maximierung der totalen Akkumulationsfläche, d.h. Grabenboden und auch Grabenwand) unter gleichzeitiger Minimierung der p-Basisfläche in den durch die Gräben gebildeten Fingern erwünscht. Somit wäre eine in dieser Hinsicht optimierte Grabengeometrie durch zugleich tiefe und breite Gräben sowie schmale Finger gekennzeichnet. Eine solche Geometrie ist jedoch nur äusserst schwierig herzustellen.

Auch den Lösungen nach dem Stand der Technik, die diese optimale Geometrie anzunähern versuchen, ist gemeinsam, dass die Bauelemente nur mit grossem technischen Aufwand herstellbar sind. Insbesondere die oxidierten Gräben können mit der heute zur Verfügung stehenden Graben-Technologie nur dann mit einer Polysilizium-Gateelektrode aufgefüllt und geschlossen werden, wenn sie eine Breite von annähernd 1µm nicht überschreiten.

### Darstellung der Erfindung

Aufgabe der Erfindung ist es deshalb, ein MOS gesteuertes Leistungshalbleiterbauelement anzugeben, das sich durch geringe Durchlassverluste und eine hohe Blockierspannung auszeichnet, das aber trotzdem mit vertretbarem technischen Aufwand hergestellt werden kann. Diese Aufgabe wird durch die Merkmale der unabhängigen Ansprüche gelöst.

Kern der Erfindung ist es also, dass zwei Arten von Fingern vorgesehen sind, nämlich sogenannte Emitterfinger und Kollektorfinger. Alle Finger werden durch die Kathode kontaktiert und von demselben Gate angesteuert. Aber nur die Emitterfinger weisen Sourcegebiete auf. Den Kollektorfingern fehlen diese Gebiete. Die Kollektorfinger können_aber mit einer dünnen, hochdotierten Schicht ausgestattet sein, die einen guten elektrischen Kontakt zu der Kathode ermöglicht. Zwischen zwei Emitterfingern sind mindestens ein, vorzugsweise mindestens drei, Kathodenfinger angeordnet.

Weitere vorteilhafte Ausführungsformen ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.
Es zeigen:
- **Fig. 1**: Einen Ausschnitt eines erfindungemässen Leistungshalbleiterbauelements im Schnitt;
- **Fig. 2-4**: Verschiedene Varianten der Emitterfinger;
- **Fig. 5-8**: Verschiedene Varianten der Kathodenfinger.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

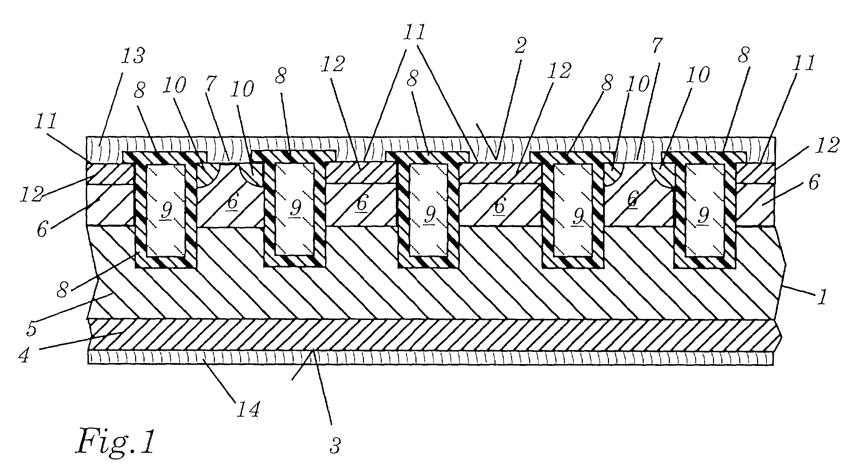

Figur 1 zeigt einen Ausschnitt aus einem erfindungsgemässen, MOS-gesteuerten Leistungshalbleiterbauelement im Schnitt. Es handelt sich dabei insbesondere um einen sogenannten Graben-IGBT. In einem Halbleiterkörper 1 sind zwischen einer ersten Hauptfläche 2 und einer zweiten Hauptfläche 3 eine Anzahl von unterschiedlich dotierten Halbleiterschichten und Gebieten angeordnet. n-dotierte Schichten und Gebiete sind mit von links oben nach rechts unten verlaufenden Linien schraffiert, während p-dotierte Gebiete mit von rechts oben nach links unten verlaufenden Linien schraffiert sind. Die Dichte der Schraffur deutet auf die Stärke der Dotierung hin. Von der zweiten Hauptfläche her folgen ein p+ dotierter Anodenemitter 4, eine erste, n dotierte Basisschicht 5 und eine zweite, p dotierte Basisschicht 6. Die erste Hauptfläche 2 ist mit einer Kathodenmetallisierung 13 bedeckt, die zweite Hauptfläche 3 mit einer Anodenmetallisierung 14. Von der ersten Hauptfläche 2 her sind ausserdem Gräben in den Halbleiterkörper 1 eingelassen. Die Gräben sind mit einem Isolierfilm 8 ausgekleidet und mit einer Steuer- oder Gateelektrode 9, z.B. aus Polysilizium gefüllt. Die Gräben bilden Finger 7 und 11, wobei nach der Erfindung zwei Arten von Fingern vorgesehen sind: Emitterfinger 7 und Kollektorfinger 11. Die beiden Arten von Fingern unterscheiden sich in der Art der Schichten und Gebiete, die sich in ihrem Bereich befinden. In den Emitterfingern 7 sind n+ dotierte Sourcegebiete 10 angeordnet. Die Kollektorfinger 11 weisen anstelle der Sourcegebiete ein höher aber mit gleicher Polarität wie die zweite Basisschicht 6 dotiertes Kollektorgebiet 12 auf. Die Anzahl zwischen zwei Emitterfingern 7 angeordneten Kathodenfinger 11 ist grundsätzlich nicht begrenzt. Bevorzugt werden aber mindestens ein, vorzugsweise drei Kathodenfinger 11 zwischen zwei Emitterfingern 7.

Die erfindungsgemässen Kathodenfinger erfüllen folgende Funktion: Im Durchlass wird das Bauelement mit einer positiven Gatespannung (z.B. 15V) betrieben. Zum Abschalten wird eine negative Spannung (z.B. -15V) an das Gate angelegt. Im Durchlassbereich bewirkt die positive Gatespannung, dass sich in den Inversionsschichten (zweite Basisschicht 6) und den Akkumulationsschichten (erste Basisschicht 5) ein zweidimensionales Elektronengas hoher Konzentration ausbildet. Der Bahnwiderstand für die Löcher in den Kollektorfingern 11 muss nun so hoch sein, dass im Durchlass nur ein vernachlässigbar kleiner Löcherstrom durch die Kollektorfinger 11 fliesst. Dies kann dadurch erreicht werden, dass der Bahnwiderstand, d.h. der Widerstand, den die Löcher erfahren, in den Kollektorfingern 11 mindestens zehnmal grösser gewählt wird als in den Emitterfingern 7. Dieser Parameter kann durch eine Dimensionierung des Querschnitts der Kollektorfinger 11 beeinflusst werden. Im Durchlass wird also das gesamte von den Kollektorfingern 11 belegte Gebiet als Akkumulationsfläche verwendet. Die erfindungsgemässe Struktur entspricht damit der optimalen Geometrie für einen Graben-IGBT, für den aufgrund der von den Kollektorfingern zur Verfügung gestellten, vergleichsweise grossen Akkumulationsfläche sowohl ein minimaler Durchlassspannungsabfall als auch eine Reduktion der Sättigungsstromdichte erreicht werden kann.

Beim Abschalten und Blockieren (negative Gatespannung) verschwindet das zweidimensionale Elektronengas und damit auch der Basisstrom des IGBTs. Das Bauelement baut am Übergang von der zweiten Basisschicht 6 zur ersten Basisschicht 5 eine Spannung auf. In der entstehenden Raumladungszone wird der Strom durch driftende Löcher getragen. Die negative Gatespannung führt zur Ausbildung eines zweidimensionalen Löchergases in den Akkumulationsschichten (zweite Basisschicht 6) und den Inversionsschichten (erste Basisschicht 5). Dieses Löchergas ist verantwortlich für den Löcherstromfluss. Beim Abschalten sind somit alle Kollektorfinger 11 am Stromfluss beteiligt und erhöhen die für den Löcherstrom zur Verfügung stehende Querschnittsfläche. Damit sinkt der Löcherstrom in den Emitterfingern während des Abschaltens. Aus diesem Grund kann beim Schalten induktiver Lasten die Gefahr von Stossionisation (dynamic avalanche) und dynamischen Latch-up verringert werden, so dass die erfindungsgemässe Leistungshalbleiterbauelemente im Idealfall sogar ohne Snubber betrieben werden können.

Die Grabengeometrie eines realisierten Ausführungsbeispiels ist durch eine Grabentiefe von 3.5 µm gekennzeichnet. Mit einem Zellabstand von 2 µm und eine Oxiddicke des Isolationsfilmes 8 von 0.3 µm besitzen die Gräben und die Finger 7 und 11 eine Breite von 0.7 µm. Die zweite Basisschicht 6 des Ausführungsbeispiels weist ein Gausssches Profil mit einer Tiefe von 2.5 µm und einer Randkonzentration von 5-10¹⁶ cm⁻³ auf. Die Tiefe der hochdotierten Sourcegebiet 10 und Kollektorgebiete 12 beträgt 0.2 µm.

Der Vorteil der erfindungsgemässen Struktur gegenüber einem konventionellen Graben-IGBT ohne Kollektorfinger besteht insbesondere darin, dass die Emitterfinger 7 durch die Präsenz und Mitwirkung der MOS gesteuerten Kollektorfinger 11 beim Abschalten wesentlich entlastet werden. Damit ist sogar ein snubberfreier Betrieb des erfindungsgemässen MOS-gesteuerten Leistungshalbleiterbauelements möglich.

Die Kollektorfinger 11 blockieren im Durchlass (positive Gatespannung) wie erläutert den Löcherstrom fast vollständig, so dass dieser vor allem über die Emitterfinger fliesst. Beim Abschalten hingegen werden die Kollektorfinger leitfähig und übernehmen einen grossen Teil des Löcherstromes. Aufgrund dieser Erkenntnis können die Emitterfinger 7 und die Kollektorfinger 11 im Hinblick auf weitere Eigenschaften durch geometrische Massnahmen optimiert werden:

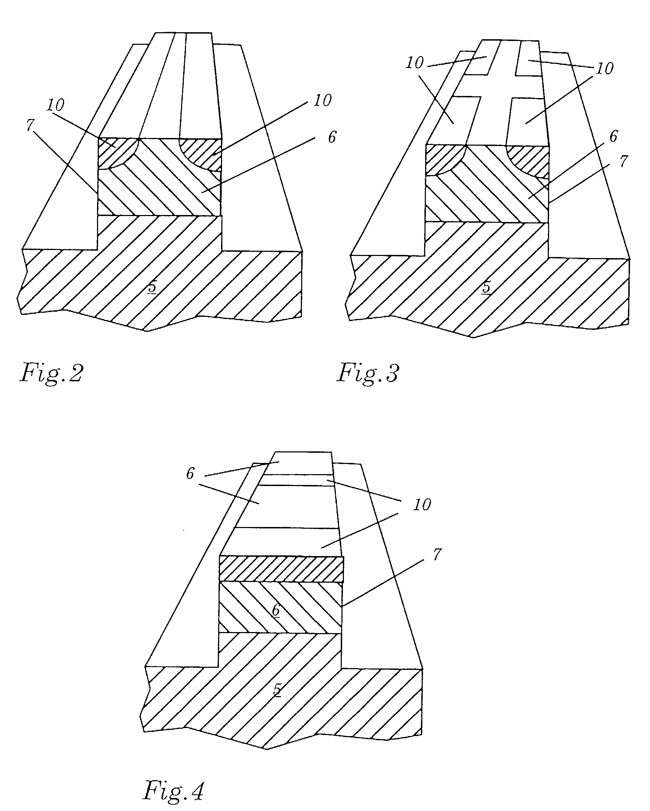

In den Figuren 2 bis 4 sind weitere Varianten von Emitterfingern im Detail dargestellt. Figur 2 zeigt den bereits erläuterten Emitterfinger 7. Im Bereich der zweiten Basisschicht 6 sind pro Finger zwei Sourcegebiete 10 vorgesehen, die entlang einer Längsrichtung des Fingers verlaufen. Die zweite Basisschicht 6 dringt zwischen den beiden Sourcegebieten in Querrichtung der Finger an die erste Hauptfläche 2.

In der Variante nach Figur 3 werden die Sourcegebiete 10 zur Erhöhung der latch-up Festigkeit entlang der Längsachse des Emitterfingers 7 unterbrochen. Bei sehr schmalen Emitterfingern 10 ist hingegen eine Strukturierung von sich in Querrichtung der Finger über die gesamte Breite erstreckenden Sourcegebieten 10 entlang der Fingerachse von Vorteil (siehe Figur 4).

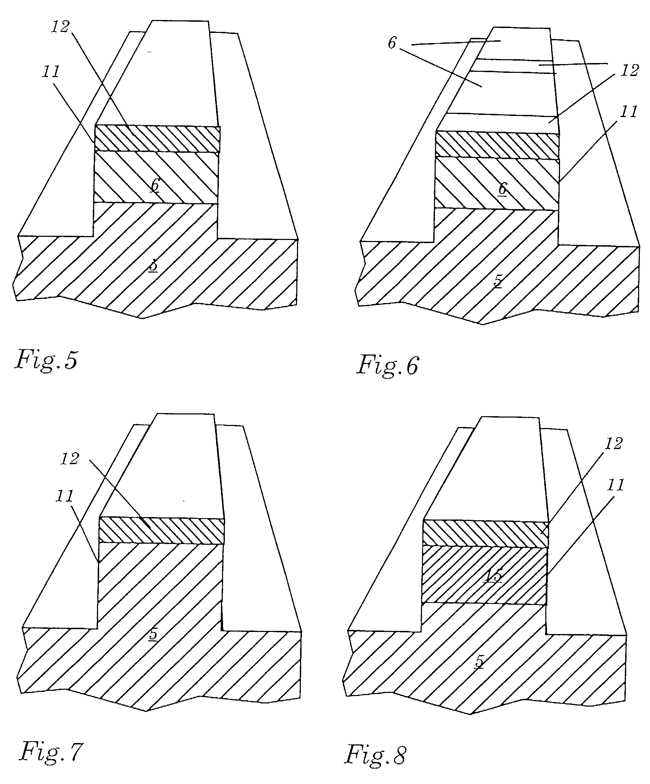

Verschiedene Varianten der Kollektorfinger 11 sind in den Figuren 5 bis 8 dargestellt. Figur 5 zeigt die Grundvariante mit in einem Kollektorgebiet 12, das über der zweiten Basisschicht 6 angeordnet ist und sich in Längsrichtung des Kollektorfingers 11 über die volle Länge des Fingers erstreckt. Gemäss Figur 6 kann das Kollektorgebiet 12 in Längsrichtung des Fingers auch unterbrochen ausgeführt sein. Dadurch werden die Streifen zu Kollektorzellen. Dadurch wird die Akkumulationsfläche erhöht. Gleichzeitig steigt aber der Widerstand über den Kollektropfad wegen der verkleinerten Querschnittsfläche. Dieser Gewinn kann verwendet werden, um die kritische Weite der Kollektorfinger zu vergrössern.

Um einen noch höheren Widerstand in den Kollektorfingern zu erreichen, kann die zweite Basisschicht 6 im Bereich der Kollektorfinger 11 auch weggelassen werden. Figur 7 zeigt ein entsprechendes Ausführungsbeispiel, bei dem das Kollektorgebiet 12 direkt anschliessend an die erste Basisschicht 5 angeordnet ist. Eine weitere Erhöhung des Bahnwiderstandes in den Kollektorfingern 11 kann dadurch erreicht werden, dass zwischen den Kollektorgebieten 12 und der ersten Basisschicht 5 eine höher als die erste Basisschicht 5 dotierte Übergangszone 15 vorgesehen wird. Figur 8 zeigt das entsprechende Ausführungsbeispiel.

Insgesamt ergibt sich mit der erfindungemässen Struktur ein MOS gesteuertes Graben-Leistungshalbleiterbauelement, bei dem die Durchlassverluste stark verringert werden können und das problemlos ein- und ausgeschaltet werden kann.

### Bezugszeichenliste

- 1: Halbleiterkörper
- 2: erste Hauptfläche
- 3: zweite Hauptfläche
- 4: Anodenemitter
- 5: erste Basisschicht
- 6: zweite Basisschicht
- 7: Emitterfinger
- 8: Isolierfilm
- 9: Steuerelektrode
- 10: Sourcegebiet
- 11: Kollektorfinger
- 12: Kollektorgebiet
- 13: Kathodenmetallisierung
- 14: Anodenmetallisierung
- 15: Übergangsschicht

## Patentansprüche

1. MOS-gesteuertes Leistungshalbleiterbauelement, insbesondere Bipolartransistor mit isoliert angeordneter Steuerelektrode (IGBT), umfassend:
(a) in einem Halbleiterkörper (1) zwischen einer ersten Hauptfläche (2) und einer zweiten Hauptfläche (3) von der zweiten Hauptfläche (3) her gesehen einen Anodenemitter (4), eine erste Basisschicht (5) und eine zweite Basisschicht (6),
(b) Emitterfinger (7), die durch Gräben gebildet werden, die von der ersten Hauptfläche (2) her bis in den Bereich der ersten Basisschicht (5) reichen und die mit einem die Oberfläche des Grabens bedekkenden Isolierfilm (8) ausgestattet sind, wobei die Gräben von der Steuerelektrode (9) ausgefüllt sind;
(c) Sourcegebiete (10), die in den Emitterfingern (7) von der ersten Hauptfläche (2) her in die zweite Basisschicht (6) eingelassen sind;
dadurch gekennzeichnet, dass
(d) Kollektorfinger (11) vorgesehen sind, die durch Gräben gebildet werden, die von der ersten Hauptfläche (2) her in den Bereich der ersten Basisschicht (5) reichen und die mit einem die Oberfläche des Grabens bedeckenden Isolierfilm (8) ausgestattet sind, wobei die Gräben von der Steuerelektrode (9) ausgefüllt sind und wobei in den Kollektorfingern (11) von der ersten Hauptfläche (2) her ein höher als die zweite Basisschicht (6) dotiertes Kollektorgebiet (12) eingelassen ist,
(e) zwischen zwei Emitterfingern (7) mindestens ein, vorzugsweise mindestens drei, Kollektorfinger (11) vorgesehen sind.

2. Leistungshalbleiterbauelement nach Anspruch 1, dadurch gekennzeichnet, dass pro Emitterfinger (7) zwei Sourcegebiete (10) vorgesehen sind, zwischen denen die zweite Basisschicht (6) an die erste Hauptfläche (2) dringt.

3. Leistungshalbleiterbauelement nach Anspruch 1, dadurch gekennzeichnet, dass sich das Sourcegebiet (7) in einer Querrichtung der Emitterfinger (7) über die gesamte Breite des Emitterfingers (7) erstreckt.

4. Leistungshalbleiterbauelement nach Anspruch 2 oder 3, dadurch gekennzeichnet, dass, dass die Sourcegebiete (10) entlang einer Längsachse des Emitterfingers (7) unterbrochen sind.

5. Leistungshalbleiterbauelement nach einem der Ansprüche 1 bis 4, dadurch gekennzeichnet, dass sich das Kollektorgebiet (12) in Querrichtung des Kollektorfingers (11) über die gesamte Breite des Kollektorfingers (11) erstreckt.

6. Leistungshalbleiterbauelement nach Anspruch 5, dadurch gekennzeichnet, dass das Kollektorgebiet (12) in einem Kollektorfinger (11) entlang einer Längsachse des Kollektorfingers (11) unterbrochen ist.

7. Leistungshalbleiterbauelement nach einem der Ansprüche 1 bis 4, dadurch gekennzeichnet, dass ein Kollektorfinger(11) anstelle der zweiten Basisschicht (6) eine vergrösserte erste Basisschicht (5) aufweist.

8. Leistungshalbleiterbauelement nach Anspruch 7, dadurch gekennzeichnet, dass zwischen den Kollektorgebieten (12) und der ersten Basisschicht (5) eine höher, aber mit derselben Polarität wie die erste Basisschicht (5) dotierte Ubergangsschicht (15) vorgesehen ist.
